# EUROPEAN PATENT APPLICATION

(11) **EP 4 675 679 A1**
(43) Date of publication of application: **07.01.2026**
(21) Application number: 25183585.6
(22) Date of filing: 18.06.2025
(51) Int. Cl.: H01L 23/367, H01L 23/473

(54) **INTEGRATED CIRCUIT COOLING UTILIZING WIRE BONDING ON METALLIZED LAYER**

(30) Priority: 03.07.2024 US 202418763600
(71) Applicant: Google LLC, Mountain View, CA 94043 (US)
(72) Inventor: DE KOCK, Konrad, Mountain View, California 94043 (US); TANG, Yingshi, Mountain View, California 94043 (US); SAMADIANI, Emad, Mountain View, California 94043 (US); WANG, Yingying, Mountain View, California 94043 (US); UDHAYAKUMAR, Sudharshan Sugavanesh, Mountain View, California 94043 (US); MADHUSUDAN, Iyengar K., Mountain View, California 94043 (US)
(74) Representative: Betten & Resch

(57) **Abstract**

A semiconductor die includes a metalized layer on an upper surface of the semiconductor die and a plurality of metal wires having a defined shape. At least one end of each of the plurality of metal wires is bonded to the metalized layer and an upper portion of each of the plurality of metal wires may extend at least partially in parallel to the metalized layer of the semiconductor die. The plurality of metal wires are arranged in a sequence such that a channel is formed by a space between the metalized layer of the semiconductor die and the upper portion of each of the metal wires that may extend at least partially in parallel to the metalized layer. The upper portion of each of the plurality of metal wires is configured to be flush with an inner surface of a cover. A cooling system including such a semiconductor die is also provided.

## Description

### BACKGROUND

Advancements in the semiconductor industry have led to integrated circuits with higher computing power. Such high-power integrated circuits require semiconductor dies that can withstand a high power density as the increase in power density results in an increase in heat generation by the semiconductor dies. Consequently, effective die cooling is necessary to regulate die temperature during operation to preserve the lifespan of the semiconductor and prevent die malfunction. Typical methods of die cooling include cold plates, heat sinks, and thermal interface materials.

### BRIEF SUMMARY

Aspects of this disclosure are directed to a system and method for cooling integrated circuits using an arrangement of wires bonded to a metallized layer on a semiconductor die. The arrangement of wires includes a plurality of metal wires bonded to the metalized layer and arranged in a sequence, thereby forming a channel. An upper portion of each wire is configured to be flush with an inner surface of a cover. The cover may include openings, such as an inlet and an outlet, such that cooling materials can enter through the inlet and be directed through the channel formed by the plurality of metal wires before exiting through the outlet.

One aspect of the disclosure provides a semiconductor die, comprising a metalized layer on an upper surface of the semiconductor die; and a plurality of metal wires having a defined shape, wherein at least one end of each of the plurality of metal wires is bonded to the metalized layer and an upper portion of each of the plurality of metal wires extends at least partially in parallel to the metalized layer of the semiconductor die, the plurality of metal wires arranged in a sequence such that a channel is formed by a space between the metalized layer of the semiconductor die and the upper portion of each of the metal wires that extends at least partially in parallel to the metalized layer, wherein the upper portion of each of the plurality of metal wires is configured to be flush with an inner surface of a cover.

In some examples, each of the plurality of metal wires may have a diameter ranging from 15µm to 500µm. In some examples the diameter may range from 15µm to 200µm. In some examples, the plurality of metal wires includes ribbon bonds.

In some examples, one or more attributes of the plurality of wires are not uniform across the metalized layer of the semiconductor die. The one or more attributes ay include wire density, metallic attachment density, wire height, wire diameter, wire pitch, or wire material. In other examples, the one or more attributes comprise an orientation of the plurality of wires.

Another aspect of the disclosure provides a cooling system, comprising: a semiconductor die including an upper surface with a metalized layer; a plurality of metal wires having a defined shape, wherein at least one end of each of the metal wires is bonded to the metalized layer of the semiconductor die and an upper portion of each of the plurality of metal wires extends at least partially in parallel to the metalized layer of the semiconductor die, the plurality of metal wires arranged in a sequence such that a channel is formed by a space between the metalized layer of the semiconductor die and the upper portion of each of the metal wires that extends at least partially in parallel to the metalized layer; and a cover fixed to the metalized layer on the upper surface of the semiconductor die, wherein the upper portion of each of the plurality of metal wires is flush with an inner surface of the cover. The channel may be configured to direct a flow of a cooling liquid through the space under the plurality of metal wires. Each wire of the plurality of metal wires may be attached to the metalized layer on both ends, am/or may be shaped in a partially rectangular shape, rounded, etc. The cover may include openings for fluid to flow through the channel, the openings including an inlet for cooling liquid to enter the channel and an outlet for the cooling liquid exiting the channel. A location and a size of the openings may be configured to control a flow rate of the cooling liquid through the channel. The semiconductor die includes a lower surface, the lower surface attached to a ball grid array layered on top of a package substrate. The cover may be fixed to the metalized layer of the semiconductor die using a sealant. A thickness of the sealant may be configured to minimize a distance between the inner surface of the cover and the upper portion of each of the plurality of metal wires.

### BRIEF DESCRIPTION OF THE DRAWINGS

In the drawings, which are presented in simplified form and are not drawn to precise scale:
Fig. 1 is a cross-sectional view of an example arrangement of metal wires on a semiconductor die according to aspects of the disclosure.
Figs. 2A-2D are side views of example configurations of individual metal wires according to aspects of the disclosure.
Fig. 3 is a cross-sectional view of a second example arrangement of metal wires on a semiconductor die according to aspects of the disclosure.
Fig. 4A is a perspective top view of an example arrangement of metal wires according to aspects of the disclosure.
Fig. 4B is a perspective top view of an example arrangement of metal wires according to aspects of the disclosure.
Fig. 5 is a side cross-sectional view of a cooling system including the semiconductor die of Fig. 1.
Fig. 6 is a side cross-sectional view of a cooling system including a third example arrangement of metal wires on a semiconductor die according to aspects of the disclosure.

### DETAILED DESCRIPTION

### Overview

Aspects of the disclosure relate to a system and method for cooling integrated circuits using an arrangement of wires bonded to a metallized layer on a semiconductor die. The semiconductor die includes a metalized layer on an upper surface of the die and a plurality of metal wires bonded to the metalized layer. The plurality of metal wires may have a defined shape, where at least one end of each of the metal wires is bonded to the metalized layer. An upper portion of each of the metal wires may extend at least partially in a lateral direction. In some examples, the upper portion may extend partially towards a direction parallel to a surface of the metallized layer. In other examples, the upper portion may extend parallel to the surface of the metallized layer. The plurality of metal wires can be arranged in a sequence such that a channel is formed by a space between the metalized layer and the upper portion of each metal wire. The upper portion of each metal wire may be flush with an inner surface of a cover. The semiconductor die having the metalized layer with the plurality of metal wire attachments includes an integrated cooling system that stabilizes the chip package temperature during operation. This eliminates the need for a cold plate, heat sink, or any thermal interface materials, such as a grease.

The metal wires attached to the semiconductor die increase the surface area of the semiconductor die that comes into contact with the cooling material. The cooling material may include liquid coolant, water, cold air, or other materials. The increased surface area of the semiconductor die increases the amount of heat dissipation from the chip package. The metal wire attachments may be positioned or arranged on the semiconductor die to maximize surface area in locations where large amounts of heat is generated by the chip package. For example, the metal wire density may be increased in locations that generate the most heat on the chip.

The cooling system including the semiconductor die may further include a cover extending over the upper surface of the semiconductor die having the metal wire attachments. The cover may have one or more openings through which the cooling material may be injected.

### Semiconductor Die

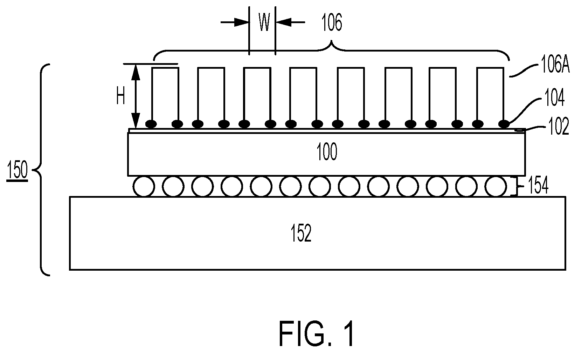

Fig. 1 is a cross-sectional view of an example arrangement of metal wires on a semiconductor die. As shown in Fig. 1, the semiconductor die 100 may be packaged within a chip package 150. The chip package 150 may include the semiconductor die 100 or semiconductor chip having a lower surface attached to a ball grid array 154. The ball grid array 154 may be layered on top of a package substrate 152 or a system printed circuit board. An upper surface of the semiconductor die 100 includes a metalized layer 102. A plurality of metal wires 106 are attached to the metallized layer 102 on the upper surface of the die 100. In some examples, the metallized layer 102 may be made out of metals such as aluminum, nickel, chromium, platinum, etc., metal alloy, or any of a variety of other materials. The metallized layer 102 may be formed on the upper surface of the die 100 using vacuum deposition, chemical vapor deposition, or physical vapor deposition, or other conventional metallization techniques.

The plurality of metal wires 106 may be arranged and structured according to the heat dissipation and power map requirements of the chip package. Attaching the metal wires 106 directly on the metalized layer 102 on the upper surface of the die 100 improves cooling efficiency of the chip package 150. The metal wires 106 work as fins and increase the heat transfer area of the semiconductor die 100 by increasing the surface area of the semiconductor die that is exposed to cooling material, such as cooling liquid or cold air. In some examples, the cooling liquid may be water. The metal wires 106 can be any metal or metal alloy chosen based on the heat dissipation requirements. In some examples, copper and aluminum wires may be used. The wire thickness and the wire diameter may vary based on the heat dissipation requirements. In some examples, the metal wires may have a diameter ranging from 15 um to 500um. In some examples, the diameter of the metal wires may mostly be within a range of 15um to 200 um. The metal wires may have any of a variety of shapes, several examples of which are described herein. In some examples, only one end of each metal wire may be bonded to the metalized layer. In other examples, both ends of the metal wire may be bonded to the metalized layer.

The wires may be attached to the metalized layer by soldering, welding, wire bonding, ribbon bonding, heat compression or any other method that may be used to create metal to metal bonding between the metalized die surface and the metal wire. The plurality of metal wires may include one or more attributes that may be optimized based on the heat dissipation and power map requirements for the die and its application. The one or more attributes may include wire density, metallic attachment density, wire height H, wire width W, wire diameter, wire pitch, or wire material. In some examples, the one or more attributes may include an orientation of the plurality of wires. In other examples, the one or more attributes may not be uniform across the metalized layer of the semiconductor die. For example, mixed wire material choices, wire diameters, wire heights, widths, wire attachment density, wire attachment orientations, or bend styles can be attached on a single die surface based on local heat density variation across a die, heat dissipation requirement variations, or coolant flow requirements.

In some examples, as shown in Fig. 1, the upper portion of the metal wires 106A may be flattened. Each of the plurality of metal wires 106A may be shaped in a partially rectangular shape and each wire may be attached to the metalized layer 102 on both ends via a metallic attachment 104. The flattened upper portion of the metal wires 106A may be flush with an inner surface of a cover to make a flat contact area between the metal wires and the cover.

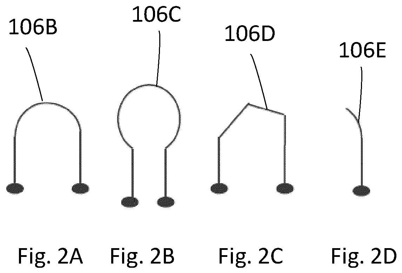

Figs. 2A-2D are side views of example configurations of individual metal wires. As shown in Fig. 2A, in some examples, the upper portion of the metal wire 106B may be curved forming a U-shape. Metal wire 106B may include two ends each having a straight portion that tapers inward to form a convex curved U-shape at the upper portion of the metal wire.

As shown in Fig. 2B, in some examples, the upper portion of the metal wire 106C may be curved, forming a lightbulb shape. Metal wire 106C may include two ends each having a straight portion that first tapers outward and then tapers inward to form a partially circular shape at the upper portion of the metal wire. In some examples, the metal wire 106C includes an open circular shape having two ends that transition into a straight line.

As shown in Fig. 2C, in other examples, the upper portion of the metal wires 106D may be angled forming a V-shape. Metal wire 106D may include two ends each having a lower straight portion. Each lower straight portion of the metal wire 106D may be of a different length. Each lower straight portion of metal wire 106D may transition into an upper straight portion of the upper portion of the metal wire. Each upper straight portion may be of a different length and connect at a point on the upper portion of the metal wire forming a tip.

As shown in Fig. 2D, in further examples, the metal wire 106E may only be attached on one end to the metallized layer. Metal wire 106E may include one straight portion that tapers outward forming an upper portion having a curve. The upper portion of metal wire 106E may taper outward in any direction from the straight portion. Straight portion of metal wire 106E is attached on one end to the metallized layer.

While several examples are illustrated in Figs. 2A-2D, the metal wires are not limited as such and may include other forms and shapes. By way of example only, portions indicated as being straight in the examples above can be bent or curved, distances between attached ends of the wire can be varied, heights of the wires can be varied, and shapes of the wires can be varied. In some examples, different metal wire shapes may be used in one arrangement on the metallized layer, forming one or more channels across the metalized layer.

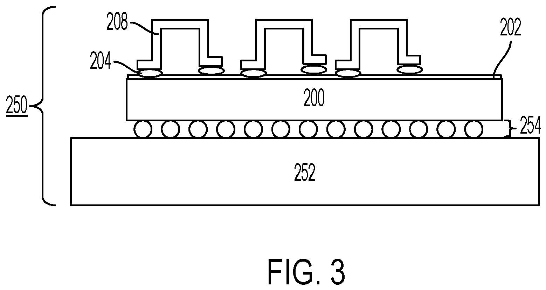

Fig. 3 is a cross-sectional view of a second example arrangement wherein ribbons 208 are ribbon-bonded to a metallized layer 202 of a semiconductor die 200. Semiconductor die 200 is packaged in a chip package 250 coupled to a system printed circuit board (PCB) 252 using connection mechanism 254, such as a ball grid array. Ribbons 208 may be shaped in any configuration similar to the metal wires described in the examples above, but with an increased thickness or width in a lateral direction. The ribbons 208 may be bonded to the semiconductor die 200 using metallic attachments 204. Ribbon bonding with thicker wires can be used to form thicker fins for structural benefit. The shape and the length of the ribbons can be extended and optimized to increase the heat transfer area. In some examples, the ribbons may have a curved upper portion. In other examples, the ribbons may have a flattened upper portion forming a partially rectangular shape. The flattened portion of the partially rectangular shaped ribbons may be flush with a cover for minimum coolant bypass. In some examples, as shown in Fig. 3, the ribbons 208 may be attached to the metalized layer 202 using metallic attachments 204.

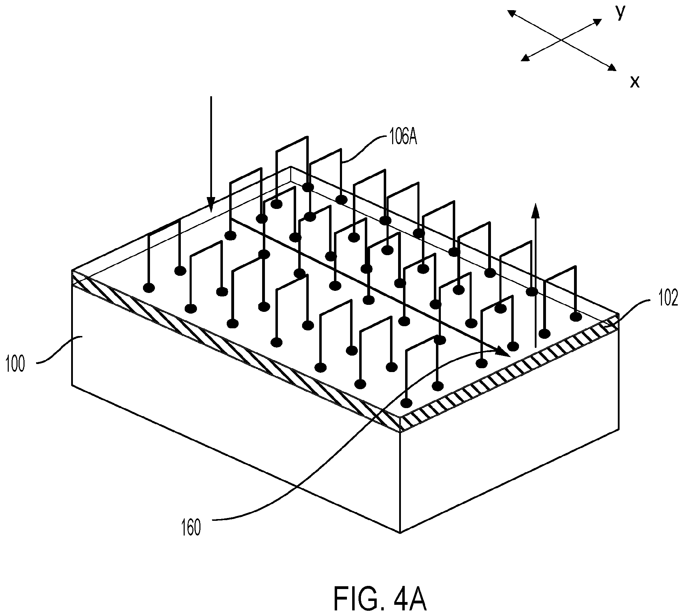

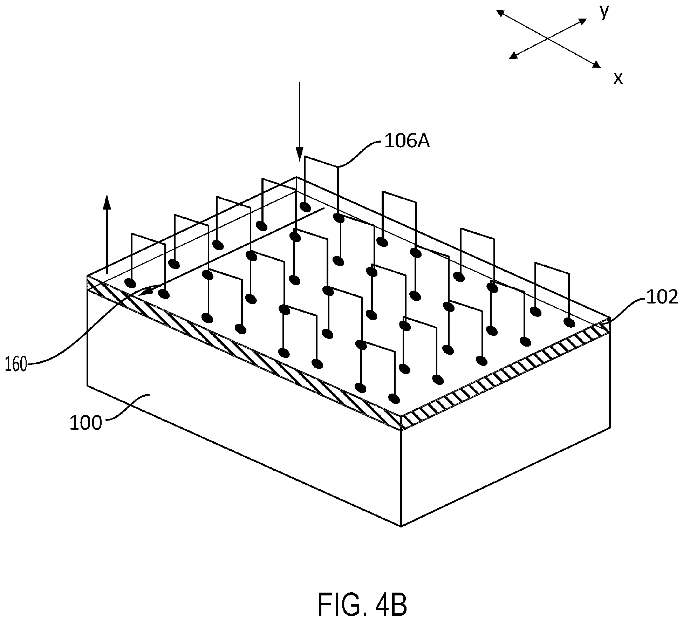

Fig. 4A and 4B are perspective top views of example arrangements of metal wires. A plurality of metal wires 106A may be arranged over the upper surface of the semiconductor die 100 such that several channels 160 are formed to guide sufficient water flow rate corresponding to chip hotspots and the power map. The space between the upper portion of the metal wires 106A and the metalized layer 102 forms a channel 160 that extends through the arrangement of the metal wires 106A. The cooling liquid or cold air can be channeled through such a channel 160. Based on chip hotspots and a power map, the channel 160 may be configured to direct cooling material at required flow rates to the chip hotspots to increase the heat transfer efficiency. In some examples, flow bypass is minimized between the cover and the flattened upper portions of the metal wires 106A due to the flat contact area between the metal wires and the cover.

### Cooling System

Aspects of this disclosure relate to a cooling system including a semiconductor die as described above. The semiconductor die includes an upper surface with a metalized layer. Each of the plurality of metal wires has a defined shape. At least one end of each of the metal wires is bonded to the metalized layer of the semiconductor die and an upper portion of each of the plurality of metal wires extends partially towards a direction parallel to the metalized layer of the semiconductor die. The plurality of metal wires is arranged in a sequence such that a channel is formed by a space between the metalized layer of the semiconductor die and the upper portion of each of the metal wires. The cooling system may further include a cover that is fixed to the semiconductor die, such that it extends over the metallized layer and forms a housing for the metal wires or ribbons attached to the metallized layer. The upper portion of each of the metal wires may be flush with an inner surface of the cover.

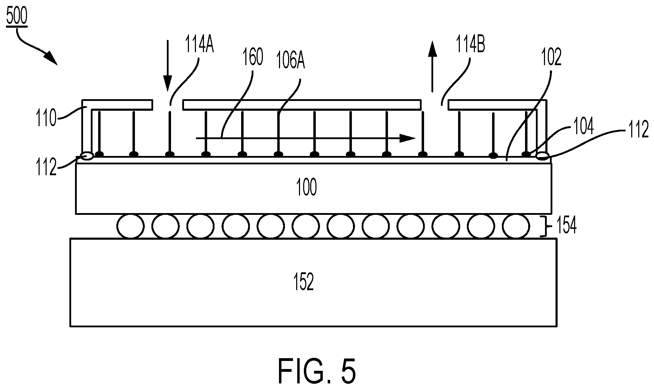

Fig. 5 is a side cross-sectional view of a cooling system including the semiconductor die of Fig. 1. As shown in Fig. 5, the channel 160 is formed by the space between the metalized layer 102 and the upper portion of the metal wires 106A that is flush with an inner surface of the cover 110. The channel 160 is configured to direct a flow of cooling liquid or air through the space under the plurality of metal wires 106A. The cover 110 may be attached to the metalized layer 102. The cover 110 may encase the metal wires 106A attached to the upper surface of the semiconductor die 100. The cover 110 may have one or more openings 114A, 114B and the location of the openings may vary depending on the areas of high heat generation of the chip package. The openings 114A, 114B may be used to inject cooling liquid or cold air into the channels 160 extending through the plurality of metal wires 106A. In some examples, the openings 114A, 114B may be used to create a flow cycle in and out of the channels 160. In some examples, as shown in Figs. 4A and 5, the plurality of metal wires 106A may be arranged so that the flow cycle through channel 160 moves along an x-axis along a length of the die 100. In other examples, as shown in Figs. 4B, the plurality of metal wires 106A may be arranged so that the flow cycle through channel 160 move along a y-axis along a width of the die 100.

In some examples, the cover may include openings for fluid to flow through the channel, the openings may include an inlet for cooling liquid to enter the channel and an outlet for the cooling liquid exiting the channel. The number and the size of the openings may be varied to accommodate a required level of heat dissipation. Different flow rate or flow direction can be implemented according to the wire placement. In some examples, air cooling by blowing cool air through the channels can be implemented. The shapes, size, and orientation of the metal wires may be varied based on factors such as a size of the heat transfer area and a pressure drop of the cooling liquid.

As shown in Fig. 5, the cover 110 and the metalized layer 102 of the die 100 may be sealed together using a sealant 112. In some examples, the sealant thickness may minimize any residual gap between the inner surface of the cover and the upper portion of the metal wires to minimize flow bypass. Some examples of the sealant may include a rubber, plastic, copper, or other material.

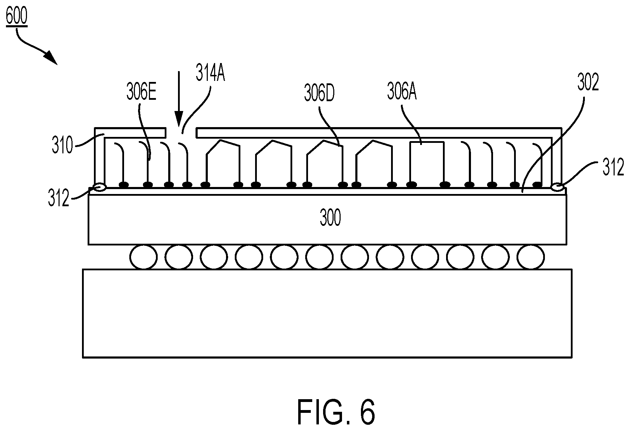

Fig. 6 is a side cross-sectional view of a cooling system including a third example arrangement of metal wires on a semiconductor die according to aspects of the disclosure. Cooling system 600 may be configured similarly to cooling system 500 and semiconductor die 300 may be similar to semiconductor dies 100, 200. In the example of Fig. 6, a combination of metal wires 306A, 306D, 306E having different shapes may be arranged to form one or more channels. For example, some metal wires may be rectangular while others are curved or angled or only bonded on one end to the metalized layer 302. In this example, despite the different shapes, an upper portion of each shape is partially flush, or nearly flush, with the inner surface of the cover 310. The cover 310 and the metalized layer 302 are sealed together using sealant 312. The cover 310 may include an opening 314A which allows for fluid or air to enter the channel, a flow cycle may flow along a width of the die 300 and exit through a second opening (not shown).

Although the implementations disclosed herein have been described with reference to particular features, it is to be understood that these features are merely illustrative of the principles and applications of the present implementations. It is therefore to be understood that numerous modifications, including changes in the sizes of the various features described herein, may be made to the illustrative implementations and that other arrangements may be devised without departing from the spirit and scope of the present implementations. In this regard, the present implementations encompass numerous additional features in addition to those specific features set forth in the paragraphs above.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many examples. Further, the same reference numbers in different drawings can identify the same or similar elements.

## Claims

1. A semiconductor die, comprising:
a metalized layer on an upper surface of the semiconductor die; and
a plurality of metal wires having a defined shape, wherein at least one end of each of the plurality of metal wires is bonded to the metalized layer and an upper portion of each of the plurality of metal wires extends at least partially in parallel to the metalized layer of the semiconductor die, the plurality of metal wires arranged in a sequence such that a channel is formed by a space between the metalized layer of the semiconductor die and the upper portion of each of the metal wires that extends at least partially in parallel to the metalized layer, and
wherein the upper portion of each of the plurality of metal wires is configured to be flush with an inner surface of a cover.

2. The semiconductor die of claim 1, wherein each of the plurality of metal wires has a diameter ranging from 15 µm to 500 µm; and
wherein optionally each of the plurality of metal wires has a diameter ranging from 15 µm to 200 µm.

3. The semiconductor die of claim 1 or claim 2, wherein the plurality of metal wires includes ribbon bonds.

4. The semiconductor die of any one of claims 1 to 3, wherein one or more attributes of the plurality of wires are not uniform across the metalized layer of the semiconductor die.

5. The semiconductor die of claim 4, wherein the one or more attributes comprise wire density, metallic attachment density, wire height, wire diameter, wire pitch, or wire material.

6. The semiconductor die of claim 4 or claim 5, wherein the one or more attributes comprise an orientation of the plurality of wires.

7. The semiconductor die of any one of claims 1 to 6, wherein one or more of the plurality of metal wires is rectangularly shaped and bonded to the metallized surface at both ends; and/or
wherein one or more of the plurality of metal wires is curved at the upper portion.

8. A cooling system, comprising:
the semiconductor die according to any one of claims 1 to 7;
and
a cover fixed to the metalized layer on the upper surface of the semiconductor die,
wherein the upper portion of each of the plurality of metal wires is flush with an inner surface of the cover.

9. The system of claim 8, wherein the channel is configured to direct a flow of a cooling liquid through the space under the plurality of metal wires.

10. The system of claim 8 or claim 9, wherein each wire of the plurality of metal wires is attached to the metalized layer on both ends.

11. The system of claim 10, wherein each of the plurality of metal wires is shaped in a partially rectangular shape; and/or
wherein the upper portion of each of the plurality of metal wires is rounded.

12. The system of any one of claims 8 to 11, wherein the cover includes openings for fluid to flow through the channel, the openings including an inlet for cooling liquid to enter the channel and an outlet for the cooling liquid exiting the channel.

13. The system of claim 12, wherein a location and a size of the openings is configured to control a flow rate of the cooling liquid through the channel.

14. The system of any one of claims 8 to 13, wherein the semiconductor die includes a lower surface, the lower surface attached to a ball grid array layered on top of a package substrate.

15. The system of any one of claims 8 to 14, wherein the cover is fixed to the metalized layer of the semiconductor die using a sealant; and
wherein optionally a thickness of the sealant is configured to minimize a distance between the inner surface of the cover and the upper portion of each of the plurality of metal wires.
